Europäisches Patentamt

European Patent Office

Office européen des brevets

(19)

(11) Numéro de publication: **0 082 902 B1**

(12) **FASCICULE DE BREVET EUROPEEN**

(45) Date de publication du fascicule du brevet:
27.11.85

(21) Numéro de dépôt: 81430045.5

(22) Date de dépôt: 29.12.81

(51) Int. Cl.⁴: **H 01 R 43/02**, H 01 L 21/48,
B 23 K 3/06

(54) Procédé pour souder les broches aux oeillets des conducteurs formés sur un substrat céramique.

(43) Date de publication de la demande:
06.07.83 Bulletin 83/27

(45) Mention de la délivrance du brevet:
27.11.85 Bulletin 85/48

(84) Etats contractants désignés:
DE FR GB

(56) Documents cités:
US - A - 3 921 285
US - A - 4 206 542

IBM TECHNICAL DISCLOSURE BULLETIN, vol.12, no.1,
juin 1969, New York (US) R.F. BUCZAK et al.: "Solder
ring applicator tool", pages 15, 16
IBM TECHNICAL DISCLOSURE BULLETIN, vol.14, no.7,
décembre 1971, New York (US) G. SABOL et al.: "Solder
creme dispensing nozzle", pages 2090
IBM TECHNICAL DISCLOSURE BULLETIN, vol.20, no.2,
juillet 1977, New York (US) D.L. RIVENBURGH et al.:
"Cast-solder preloading for stacked modules", pages
545-546
TECHNICAL DIGEST, no.55, juillet 1979, New York (US)
S.L. DIGGS et al.: "Foam flux applicator for printed
circuit boards", page 11

(73) Titulaire: **International Business Machines Corporation,
Old Orchard Road, Armonk, N.Y. 10504 (US)**
(84) Etats contractants désignés: **DE GB**

(73) Titulaire: **Compagnie IBM FRANCE, 5 Place Vendôme,
F-75000 Paris 1er (FR)**
(84) Etats contractants désignés: **FR**

(72) Inventeur: **Bitaillou, Alex, 15 rue du Vercors,
F-91220 Bretigny Sur Orge (FR)**
Inventeur: **Lemoine, Jean-Marie, 16 rue Bizet,
F-91240 Saint Michel Sur Orge (FR)**
Inventeur: **Masson, Jean, 19 Chemin de la Vieille
Garenne, F-77123 Noisy/Ecole (FR)**

(74) Mandataire: **Klein, Daniel Jacques Henri, Compagnie
IBM France Département de Propriété Industrielle,
F-06610 La Gaude (FR)**

## Description

La présente invention concerne le domaine de la fabrication des modules électroniques et plus particulièrement un procédé pour souder les têtes de broches aux oeillets de conducteurs, formés selon une configuration déterminée à la surface d'un substrat céramique.

L'industrie des circuits intégrés à semi-conducteurs fait de plus en plus appel aux modules électroniques pour servir d'empallage aux microplaquettes de silicium. Ces modules électroniques, dans un mode de réalisation courant, comprennent essentiellement un substrat céramique revêtu d'une configuration déterminée de conducteurs métalliques qui relient les plots de soudure de la microplaquette aux broches (Flip-Chip technique). Ces dernières assurent les liaisons mécaniques et électriques avec le monde extérieur. L'ensemble est généralement protégé par un capot métallique ou plastique. Les conducteurs, aux emplacements des broches, présentent des oeillets. Un problème important, qui se pose sur les lignes de fabrication de ces modules est d'assurer de bonnes liaisons électrique et mécanique entre la tête de la broche, généralement renflée, et la partie du conducteur en forme d'oeillet à cet endroit.

L'état de la technique comporte de très nombreux procédés qui ont été développés pour assurer la liaison électrique entre cet oeillet et la tête de broche.

Un premier procédé classique consiste à appliquer un anneau de soudure autour de la tête de broche, et de passer ensuite le module dans un four. Une description de ce procédé peut être trouvée dans un article intitulé: «Solder Ring Application Tool» par R.F. Buczak et al, paru dans la publication de l'IBM Technical Disclosure Bulletin, Vol. 12, No. 1, juin 1969, pages 16 et 16.

Ce procédé implique pratiquement l'utilisation de broches cylindriques (donc sans tête renflée), et présente alors des inconvénients lors de la manipulation du substrat muni de ses broches. En outre le moindre déplacement de l'anneau de soudure ou son mauvais placement peut causer une soudure incomplète ou même un court-circuit entre deux têtes de broches.

On a pensé également assurer cette soudure dans un bain électrolytique comme le suggère l'article: «Pin Bonding Technique» de F.C. Campagna et al, paru dans la publication de l'IBM Technical Disclosure Bulletin, Vol. 14, No. 11, avril 1972, pages 3246 et 3247. Outre sa complexité, ce procédé est très contaminant, ce qui peut nuire à la fiabilité du module une fois encapsulé.

Les substrats peuvent être également étamés par la technique de trempage bien connue. Cette technique est très coûteuse en matières premières (flux, soudure, perchloréthylène) et en main d'oeuvre (étamage et tri visuel).

Encore une autre technique classique, consiste à effectuer l'étamage au moyen d'une pâte de soudure dispensée au moment du placement de la microplaquette. Cette technique présente deux inconvénients majeurs: la dispense de la pâte sur les têtes de broche est une étape de réalisation difficile, et la présence fréquente de résidus de soudure est susceptible de causer des court-circuits entre les conducteurs.

Une technique voisine est décrite dans un article intitulé «Solder Creme Dispensing Nozzle» par G. Sabol et J. Siwy publié dans l'IBM Technical Disclosure Bulletin, Vol. 14, No. 7, decembre 1971, page 2090.

Toutes ces techniques, impliquent la liaison des têtes de broches aux oeillets avant la liaison des microplaquettes munies de billes de soudure, aux doigts conducteurs portés par le substrat céramique. A cette occasion, de la soudure venait souvent se déposer sur ces doigts, ce qui rendait l'alignement de la microplaquette plus difficile. Une des solutions retenues consistait à effectuer une étape de brossage supplémentaire pour enlever ces dépôts non désirés de soudure.

Ces inconvénients sont évités avec le procédé de la présente invention ayant comme caractéristique principale celle de la partie caractérisante de la revendication 1, et que dans son principe consiste à placer des billes de soudure sur les têtes de broches préalablement fluxées. La liaison entre les têtes de broche et les oeillets s'effectue dans un four, par la fusion des billes de soudure, par exemple simultanément avec la liaison de la microplaquette.

De façon plus détaillée le présent procédé est caractérisé en ce qu'il comporte les étapes suivantes:
. application d'une goulette de flux sur chaque tête de broche adjacente à l'oeillet correspondant,
. application d'une bille de soudure sur chaque tête de broche où elle est maintenue par l'action adhésive du flux préalablement déposé,
. chauffage pour faire fondre la bille de soudure et refroidissement pour figer la soudure et assurer une liaison permanente électrique et mécanique entre la tête de broche et l'oeillet correspondant.

L'application d'une bille de soudure sur chaque tête de broche a nécessité des équipements appropriés, dont la réalisation s'est révélée particulièrement difficile. Ces équipements sont décrits dans la partie caractérisante des revendications 3 à 8.

Le présent procédé peut être facilement automatisé et démontre une fiabilité pratiquement parfaite.

L'invention est exposée ci-après, de façon détaillée à l'aide des dessins qui représentent seulement un mode de réalisation.

La figure 1 représente une vue partiellement éclatée d'une portion d'un module électronique classique dont le capot protecteur a été retiré, et laissant apparaître le substrat céramique métallisé.

La figure 2 représente l'équipement de fluxage destiné à assurer la dispense d'une goutte de flux sur chaque tête de broche.

La figure 3 représente schématiquement une vue en coupe du substrat céramique métallisé de la figure 1 selon la ligne I-I, après fluxage.

Les figures 4a et 4B représentent respectivement un équipement de mise en agitation des billes de soudure et un équipement d'aspiration et de dispense de ces billes.

La figure 5 représente schématiquement le substrat montré sur la figure 3 après l'étape de dispense des billes de soudure.

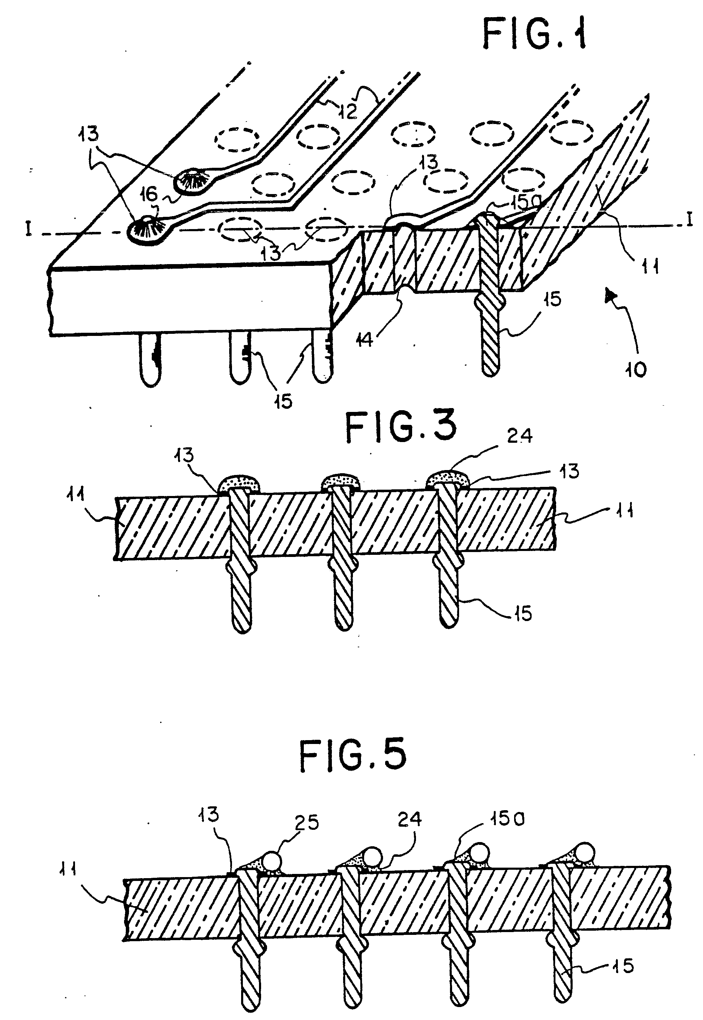

La figure 1 représente une vue partiellement éclatée d'une portion d'un module électronique 10 classique dont le capot protecteur a été retiré. Il comprend un substrat céramique 11 muni d'une configuration de conducteurs métalliques 12, qui présentent un élargissement en forme d'oeillet 13 à l'emplacement des trous 14 où sont insérées les broches de connexion 15.

Il faut comprendre qu'il existe une infinité de configurations possibles: pour l'implantation des broches (cependant elles sont généralement disposées selon une matrice avec un pas d'espacement déterminé) et pour la disposition de conducteurs métalliques.

Chaque broche 15 présente un renflement 15a sur sa partie supérieure qui constitue la tête de la broche. Après insertion de la broche dans son trou, la tête de la broche 15a doit être soudée à l'oeillet 13, cette opération une fois achevée laisse un plot de soudure 16.

La présente invention se propose de fournir un procédé nouveau pour assurer cette opération, de soudage, qui assure la liaison mécanique et électrique de la tête de broche avec l'oeillet du conducteur correspondant.

La première étape de ce procédé consiste dans la dispense d'une gouttelette de flux au-dessus de chaque tête de broche. L'équipement de dispense du flux 17 est représenté schématiquement sur la figure 2. Le flux 18 (benzylique alpha 102-1500 ou équivalent) est placé dans un réservoir en téflon 19, enfermé dans un cylindre en inox 19a, dont le fond amovible constitue le masque de fluxage 20. Ce masque est percé de trous 21 selon la configuration et le pas des broches. La pression à l'intérieur du réservoir 19 est contrôlée à partir d'un système pneumatique 22 commandé par exemple, à partir d'un circuit logique ou d'une sortie analogique d'un ordinateur (non représenté). Le flux est maintenu dans le réservoir pendant la phase de positionnement, c'est-à-dire d'approche et d'alignement du réservoir au-dessus du substrat céramique 11, puis est libéré grâce à une impulsion de pression fournie par le système 22. Le substrat 11 est disposé dans un support de substrat 23 muni de broches d'alignement (non représentées). Après que l'équipement ait été retiré, il reste au-dessus de chaque tête de broche, une gouttelette de flux 24 comme on peut s'en rendre compte sur la figure 3. Pour des têtes de broches de diamètre $\emptyset$ = 0,7 mm, il s'est révélé qu'un espacement masque-tête de 0,1 mm était souhaitable. Dans ces conditions, les trous 21 doivent avoir un diamètre de 0,4 mm, tandis que l'épaisseur de la toile constituant le masque de fluxage est de 1 mm.

La deuxième étape a pour objet de définir d'autres équipements qui puissent assurer l'aspiration, le maintien, et la libération d'une bille de soudure au-dessus de chaque tête de broche où elle sera maintenue par l'action adhésive de la gouttelette du flux déposé lors de la première étape.

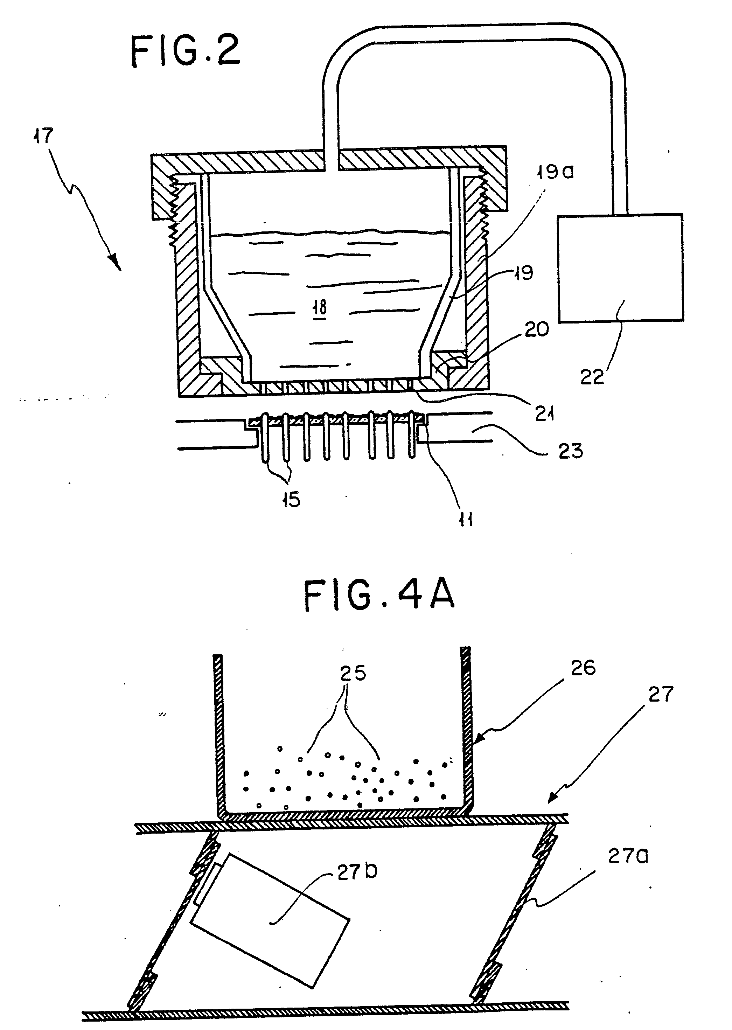

Les billes de soudure Pb/Sn 90/10 choisies pour cette application, ont un diamètre de 0,7 mm, elles sont par ailleurs très légères, on a donc prévu de les mettre en vibration, avant de les aspirer, c'est le rôle de l'équipement montré sur la figure 4A. Les billes 25 sont agitées dans un bol vibrant 26 commandé par un vibrateur 27. Ce bol vibrant doit être réalisé avec un matériau suffisamment élastique pour que les billes de soudure puissent rebondir dessus. Un bol vibrant réalisé en polyéthylène a donné entière satisfaction. Par ailleurs, les vibrations se sont révélées insuffisantes à elles seules pour mettre les billes en agitation. On a mis en évidence qu'il y avait un nombre optimum de billes de soudure qui correspondait en fait à une monocouche de billes quand le bol était au repos. Dans la réalisation préférée sus-mentionnée, le bol était un parallélépipède de base carrée (70 mm × 70 mm) et de hauteur H = 80 mm. Le vibrateur 27 comprenait une table reposant sur deux ressorts obliques 27a, un électro-aimant 27b assurant la mise en vibration de l'esemble.

Dans ces conditions, les billes vibraient sur une hauteur d'environ 20 mm. D'autres modes de réalisation de la mise en agitation des billes, peuvent être envisagés par exemple avec un récipient dont le fond est poreux et reçoit de l'air comprimé.

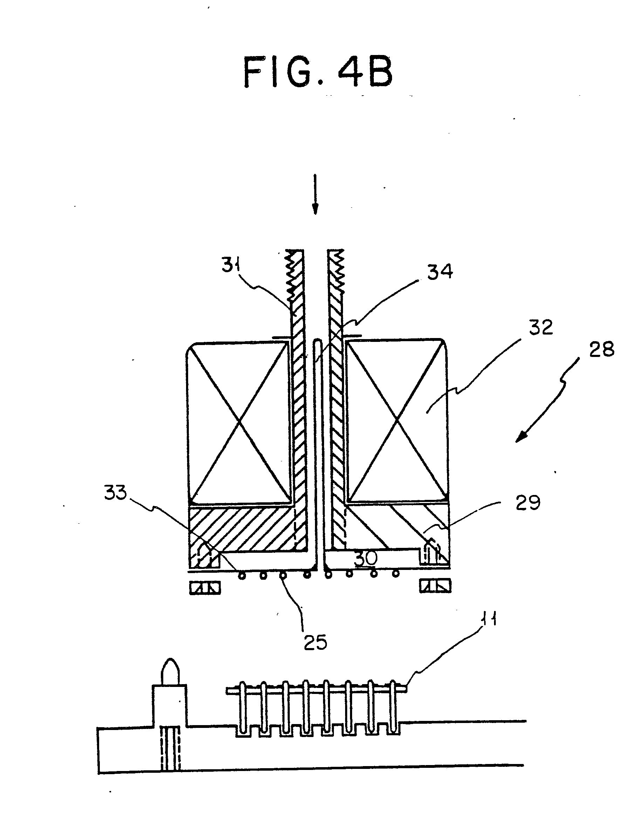

Sur la figure 4B, on a représenté un équipement 28 d'aspiration et de dispense des billes de soudure, qui vient aspirer les billes en mouvement dans le bol vibrant 26. Cet équipement comprend un bâti en fer doux 29 qui peut être de forme ciculaire, et qui définit une chambre d'aspiration 30 en liaison, par une tubulure 31, avec un dispositif à vide commandé (non représenté). Un électro-aimant 32 est disposé le long de la tubulure qui en constitue l'axe, il est commandé à partir de la tension du secteur (50 Hz) à travers une diode. La chambre d'aspiration est fermée par un masque d'aspiration 33 munie d'une tige 34 dont l'autre extrémité se trouve dans l'entrefer de l'électro-aimant. Le masque est constitué par une membrane de cuivre au beryllium de 0,1 mm d'épaisseur, percé de trous selon la configuration des broches sur le substrat. Le diamètre des trous d'aspiration est de 0,4 mm.

Le fonctionnement global des équipements représentés sur les figures 4A et 4B peut être compris de la manière suivante: le vibrateur 27 est d'abord mis en mouvement pour assurer l'agitation des billes 25 dans le bol vibrant 26. L'équipement 28 préalablement relié à la source de vide, est plongé dans le bol vibrant de telle sorte que la distance entre le masque d'aspiration 33 et le fond du bol soit d'environ 5 mm. Le temps nécessaire pour prendre toutes les billes est de l'ordre d'une seconde. L'équipement 28 portant les billes de soudure 25 est placé au-dessus du substrat 11 et disposé de telle sorte que la configuration des billes et celle des broches soient alignées avec cependant de préférence un léger décalage pour que la bille repose sur au moins une portion de l'oeillet. Cet alignment peut se faire grâce à la présence de broches d'alignement (non représentées) sur le support de module, qui reçoivent des évidements (non représentés) correspondants pratiqués dans le bâti de l'équipement 28 similaire à celui représenté sur la figure 2. Les billes de soudure sont donc amenées en contact avec les gouttelettes de flux correspondantes. Le vide est alors coupé, tandis que l'électro-aimant est commandé pendant environ 0,5 seconde. On a en effet remarqué que le procédé était grandement amélioré par la mise en vibration de la membrane. Celà pour effet d'aider à relâcher les billes qui restent cependant maintenues sur les têtes de broche grâce à l'action adhésive du flux.

La figure 5 représente la disposition des billes sur le substrat céramique. L'existence d'un léger décalage entre la tête de broche 15a et la bille de soudure 25 est clairement mise en évidence sur cette figure. On a remarqué que ce décalage procurait une meilleure adhésion de la bille au flux, et une meilleure soudure entre la tête de broche et l'oeillet. Il en résulte de meilleurs rendements. Il ne reste plus, de manière connue, qu'à dispenser du flux (par exemple à l'aide d'un équipement similaire à celui décrit sur la figure 2) sur les doigts aux extrémités des conducteurs à l'emplacement des billes de soudure de la microplaquette de silicium, et à poser cette microplaquette. Le substrat céramique est enfin introduit dans un four à atmosphère d'azote présentant un pic de température à 350°C, qui fond les billes de soudure et qui assure simultanément la liaison de la microplaquette avec les doigts des conducteurs déposés sur le substrat (technique dite Flip-Chip) et la liaison des têtes de broches avec les oeillets desdits conducteurs.

**Revendications**

1. Procédé pour souder les broches (15) aux oeillets (13) correspondants qui les reçoivent, ces oeillets étant disposés selon une configuration déterminée à la surface d'un substrat isolant (11), caractérisé en ce qu'il comporte les étapes suivantes:
application d'une gouttelette de flux (24) sur chaque tête de broche (15a) adjacente à l'oeillet (13) correspondant,
application d'une bille de soudure (25) sur chaque tête de broche (15a) où elle est maintenue par l'action adhésive du flux (18) préalablement déposé, chauffage pour faire fondre la bille de soudure (25) et refroidissement pour figer la soudure et assurer une liaison (16) permanente électrique et mécanique entre la tête de broche (15a) et l'oeillet (13) correspondant.

2. Procédé selon la revendication 1, caractérisé en ce que lesdites billes (25) sont alignées, mais légèrement décalées par rapport aux têtes de broches (15a).

3. Procédé selon la revendication 1 ou 2, caractérisé en ce que lesdites oeillets (13) sont les terminaisons d'une configuration de conducteurs (12).

4. Procédé selon la revendication 1, 2 ou 3, caractérisé en ce que l'étape d'application de flux comporte:
le positionnement au dessus du substrat (11), et à sa proximité, d'un réservoir (19), contenant une réserve de flux (18), dont le fond (20) est constitué par une grille, percée de trous (21), selon ladite configuration déterminée, et formant masque de fluxage, ledit réservoir étant relié à un dispositif pneumatique (22) qui maintient un vide approprié pendant la phase de positionnement,
l'envoi d'une impulsion de pression par ledit dispositif pneumatique (22) pour former une boule de flux au dessus de chaque tête de broche (15a), et
le retrait dudit réservoir (19).

5. Procédé selon l'une des revendications 1 à 4, caractérisé en ce que l'étape d'application d'une bille de soudure (25) comporte:
la mise en agitation des billes de soudure (25) dans un récipient,
l'aspiration de ces billes en mouvement par une grille (33) percée de trous selon ladite configuration déterminée et formant masque d'aspiration, ladite grille définissant avec un bâti (29) une chambre d'aspiration (30) reliée à un dispositif pneumatique par une tubulure (31),
le positionnement de ce masque d'aspiration au-dessus du substrat (11) pour aligner les billes de soudure (25) avec les têtes de broches (15a), de telle sorte que les billes viennent en contact avec les gouttelettes de flux (24) correspondantes et l'envoi d'une impulsion de pression par ledit dispositif pneumatique pour libérer les billes (25).

6. Procédé selon la revendication 5, caractérisé en ce que ledit récipient est un bol vibrant (26) réalisé dans un matériau sur lequel les billes de soudure (25) peuvent rebondir, tel que le polyéthylène, les vibrations étant assurées à partir d'un vibrateur (27).

7. Procédé selon la revendication 6, caractérisé en ce que la quantité de billes (25) dans le bol vibrant (26) correspond à une mono-couche.

8. Procédé selon la revendication 6 ou 7, caractérisé en ce que ledit bâti (29) comporte un électro-aimant (32), que ladite grille (33) est munie d'une tige (34) disposée dans l'entrefer de cet électro-aimant, qui est commandé par une source de tension alternative, simultanément à l'envoi de l'impulsion de pression pour aider à libérer les billes de soudure (25).

9. Procédé selon l'une quelconque des revendications ci-dessus, caractérisé en ce que l'étape de chauffage s'effectue dans un four à azote présentant un pic de température à 350°C.

10. Procédé selon la revendication 9, caractérisé en ce que, simultanément à la liaison des têtes de broche (15a) aux oeillets (13), on effectue la liaison des microplaquettes aux doigts conducteurs portés par le substrat (11).

**Patentansprüche**

1. Verfahren zum Anlöten von Stiften (15) an die zugehörigen Lötaugen (13), die sie aufnehmen, wobei die Lötaugen in einer bestimmten Konfiguration an der Oberfläche eines Isoliersubstrats (11) angeordnet sind, dadurch gekennzeichnet, dass es die folgenden Schritte enthält:
Auftragen eines Tröpfchens Flussmittel (24) auf jeden Stiftkopf (15a) bei dessen Berührung mit dem entsprechenden Lötauge (13),
Anlegen einer Lötkugel (25) an jeden Stiftkopf (15a), wo sie durch die Haftwirkung des vorher aufgetragenen Flussmittels festgehalten wird,
Heizung zum Schmelzen der Lötkugel (25) und Kühlung mit dem Zweck der Verfestigung des Lötmittels und der Gewährleistung einer dauernden elektrischen und mechanischen Verbindung (16) zwischen dem Stiftkopf (15a) und dem zugehörigen Lötauge (13).

2. Verfahren gemäss Anspruch 1, dadurch gegekennzeichnet, dass die besagten Kugeln (25) in bezug auf die Stiftenden ausgerichtet, aber leicht versetzt sind.

3. Verfahren gemäss Anspruch 1 oder 2, dadurch gekennzeichnet, dass die besagten Lötaugen (13) Endungen einer Leiterkonfiguration (12) sind.

4. Verfahren gemäss Anspruch 1, 2 oder 3, dadurch gekennzeichnet, dass der Schritt für die Auftragung des Flussmittels enthält:
die Positionierung eines Behälters (19), der einen Vorrat des Flussmittels (18) enthält und dessen Boden (20) durch ein Gitter mit Löchern (21) gebildet wird, über der Isolierschicht (11) und in deren Nähe, in der besagten festliegenden Konfiguration, so dass er eine Flussmittelauftragsmaske bildet, wobei der besagte Behälter mit einer pneumatischen Vorrichtung (22) verbunden ist, welche während der Positionierungsphase ein passendes Vakuum aufrechterhält,
Aussendung eines Druckimpulses durch die besagte pneumatische Vorrichtung (22), um eine Flussmittelkugel über jedem Stiftkopf (15a) zu bilden, und Rückzug des besagten Behälters (19).

5. Verfahren gemäss einem der Ansprüche 1 bis 4, dadurch gekennzeichnet, dass der Schritt des Auftragens einer Lötkugel (25) enthält:
das Schütteln der Kugeln (25) in einem Behälter,
das Absaugen dieser Kugeln in Bewegung durch ein Gitter (33) mit Löchern in der besagten vorgegebenen Konfiguration, das eine Ansaugmaske bildet, wobei das besagte Gitter mit einem Rahmen (29) eine Ansaugkammer (30) bildet, die über einen Stutzen (31) mit einer pneumatischen Vorrichtung verbunden ist,
die Positionierung dieser Ansaugmaske über der Isolierschicht (11) zum Ausrichten der Lötkugeln (25) mit den Stiftköpfen (15a), so dass die Kugeln in Kontakt mit den entsprechenden Flussmitteltröpfchen (24) gelangen, und Aussendung eines Druckimpulses durch die besagte pneumatische Vorrichtung für die Freigabe der Kugeln (25).

6. Verfahren gemäss Anspruch 5, dadurch gekennzeichnet, dass der besagte Behälter ein Rüttelbecher (26) ist, hergestellt aus einem Material, auf dem die Lötkugeln (25) aufspringen, wie Polyäthylen, wobei die Vibrationen durch ein Vibriergerät (27) erzeugt werden.

7. Verfahren gemäss Anspruch 6, dadurch gekennzeichnet, dass die Menge der Kugeln (25) im Vibrierbecher (26) einer einzigen Schicht entspricht.

8. Verfahren gemäss Anspruch 6 oder 7, dadurch gekennzeichnet, dass der besagte Rahmen (29) einen Elektromagneten (32) enthält, dass das besagte Gitter (33) mit einem Stab (34) versehen ist, der im Spalt dieser Elektromagneten angeordnet ist, welcher über eine Wechselspannungsquelle gesteuert wird, gleichzeitig mit der Ausgabe des Druckimpulses, um die Freigabe der Lötkugeln (25) zu unterstützen.

9. Verfahren nach einem der oben genannten Ansprüche, dadurch gekennzeichnet, dass die Heizstufe in einem Stickstoffofen erfolgt, der eine Temperaturspitze von 350 °C aufweist.

10. Verfahren gemäss Anspruch 9, dadurch gekennzeichnet, dass gleichzeitig mit der Verbindung der Spindelköpfe (15a) an den Lötaugen (13) die Verbindung der Mikroplättchen mit den von der Isolierschicht (11) getragenen Leiterfingern ausgeführt wird.

**Claims**

1. A method of bonding the connecting pins (15) to the corresponding eyelets (13) accommodating said pins, said eyelets being disposed on the top surface of an isolating substrate (11) in accordance with a specific pattern, characterized in that it includes the following steps:
applying a droplet of flux (24) to the head (15a) of each connecting pin adjacent to the corresponding eyelet (13),
applying a solder ball (25) to the head (15a) of each pin to which it will adhere because of the adhesive capacity of the flux (18) previously deposited thereon,
heating to cause a solder reflow of the ball (25), and allowing to cool so as to enable the solder to set and to provide a permanent electrical and mechanical bond (16) between the head (15a) of the pin and the corresponding eyelet (13).

2. The method of claim 1, characterized in that said solder balls (25) are aligned with the heads (15a) of the pins, but slightly offset relative thereto.

3. The method of claim 1 or 2, characterized in that said eyelets (13) form the ends of a pattern of conductors (12).

4. The method of claim 1, 2 or 3, characterized in that the step of applying a droplet of flux includes:
positioning over the substrate (11), and in proximity thereto, a tank (19) containing a supply of flux (18) the bottom (20) of which is comprised of a grid forming a fluxing mask and having holes (21) corresponding to said specific pattern, said tank being connected to a vacuum system (22) that maintains a suitable vacuum during the positioning phase,
causing said vacuum system (22) to supply an air pulse to cause a droplet of flux to be applied to the head (15a) of each pin, and
removing said tank (19).

5. The method of claims 1 through 4, characterized in that the step of applying a solder ball (25) includes:
vibrating the solder ball (25) in a container,
causing the moving solder balls to be drawn against a grid (33) forming a suction mask and having holes therein arranged in a pattern corresponding to said specific pattern, said grid defining, together with a frame (29), a suction chamber (30) connected to a vacuum system through a tube (31),
positioning said suction mask over the substrate (11) to align the solder balls (25) with the heads (15a) of the pins so as to cause the balls to come into contact with the corresponding droplets of flux (24),
causing said vacuum system to generate an air pulse to release the balls (25).

6. The method of claim 5, characterized in that said container is a vibrating bowl (26) made of a material such as polyethylene allowing the solder balls to bounce, the vibration being generated by a vibrating device (27).

7. The method of claim 6, characterized in that the number of solder balls (25) in said vibrating bowl (26) corresponds to a single layer of solder balls.

8. The method of claim 6 or 7, characterized in that said frame (29) includes an electromagnet (32), in that said grid (33) is fitted with a rod (34) disposed in the air gap of said electromagnet which is energized by an AC voltage source at the same time as said air pulse is generated, to thereby facilitate the release of the solder balls (25).

9. The method of any of the preceding claims, characterized in that the heating step is performed in a furnace containing a nitrogen atmosphere and having a peak temperature of 350°C.

10. The method of claim 9, characterized in that the bonding of the heads (15a) of the pins to the eyelets (13) is carried out simultaneously with the bonding of the semiconductor chips to the fingers of the conductors on the substrate (11).

# FIG.1

# FIG.3

# FIG.5

# FIG.2

# FIG.4A

# FIG. 4B